Europäisches Patentamt

(19) European Patent Office

Office européen des brevets

(11) Publication number: **0 219 122**
**B1**

(12) **EUROPEAN PATENT SPECIFICATION**

(45) Date of publication of the patent specification:
04.07.90

(51) Int. Cl.⁵: **C04B 41/88**

(21) Application number: **86114283.4**

(22) Date of filing: **15.10.86**

(54) Metallized ceramic substrate and method of manufacturing the same.

(30) Priority: **15.10.85 JP 230258/85**
**15.10.85 JP 230259/85**

(43) Date of publication of application:
**22.04.87 Bulletin 87/17**

(45) Publication of the grant of the patent:
**04.07.90 Bulletin 90/27**

(84) Designated Contracting States:
**DE FR**

(56) References cited:
**EP-A- 0 128 476**
**FR-A- 2 518 084**

(73) Proprietor: **NEC CORPORATION, 33-1, Shiba 5-chome, Minato-ku, Tokyo 108(JP)**

(72) Inventor: **Utsumi, Kazuaki, c/o NEC Corporation 33-1, Shiba 5-chome, Minato-ku Tokyo(JP)**
Inventor: **Osaka, Tetsuya, 17-12, Enokicho Tokorozawa-shi, Saitama(JP)**

(74) Representative: **Glawe, Delfs, Moll & Partner Patentanwälte, Postfach 26 01 62 Liebherrstrasse 20, D-8000 München 26(DE)**

## Description

The present invention relates to a ceramic substrate on the surface of which a metallic layer is formed (metalized ceramic substrate), and a method of manufacturing the same.

When a ceramic substrate is used for a circuit board of an electronic circuit, a heat sink, or an insulating substrate, a metallic layer must be formed on a ceramic layer. Conventional methods for forming a metallic layer on the ceramic substrate include a thin film method (e.g., sputtering or deposition), a thick film method for baking an electrode paste using screen printing, an electroless plating method, and a method in which an electrode is formed by a thin or thick film method and electrolytic plating is performed thereon.

Requirements for the metallic layer formed on the ceramic substrate are as follows. (1) The metallic layer has a good bonding property with respect to a ceramic substrate; (2) the metallic layer has a low electrical resistance; and (3) the metallic layer can be micropatterned.

In addition to the above requirements, in a packaging substrate or a heat sink which mounts a high-density, high-power device, the metallic layer must be able to be bonded to the ceramic substrate without generating thermal resistance.

The conventional methods for forming the metallic layer on the ceramic substrate cannot satisfy the above requirements, and are selectively used in accordance with applications. More specifically, for a device which requires an electrode or conductor of high precision, the thin film method is adopted. However, this method poses problems of a manufacturing cost problem and of resistance of the metallic layer since it is difficult to increase the thickness of the metallic layer with this method.

The thick film method using an electrode paste can be carried out with low cost since it has simple procedures and allows mass production. However, a wiring has a limited precision, and an electrical resistance inherent to an electrode cannot be set to be equal to that of bulk metal, thus restricting application range of the method.

The thin or thick film method and the electrolytic plating are combined to improve characteristics. However, this complicates manufacturing procedures, and increases cost, resulting in a limited application range.

In order to solve the above problems, a technique for forming a metallic layer on a ceramic substrate using an electroless plating method has been studied and developed. The technique is adopted in practice for, e.g., an alumina substrate.

However, the conventional electroless plating technique cannot provide a sufficient peel strength between the metallic layer and the ceramic substrate.

In an application, such as a packaging substrate or a heat sink for a high-power semiconductor device, which requires a low thermal resistance at an interface between the metallic layer and the ceramic substrate, the ceramic substrate is preferably bonded directly to the metallic layer. In this case, when the thick film method having a relatively high peel strength is adopted, glass or oxide for maintaining a bonding property between the ceramic substrate and the metallic layer is present therebetween, resulting in a high thermal resistance.

An aluminum nitride ceramic substrate, which recently receives attention as a high heat conductivity ceramic material, cannot provide a sufficient peel strength even if the conventional thick film method is used or an oxide or an oxygen diffusion layer is formed between the metallic layer and the ceramic substrate, thus considerably increasing the thermal resistance.

The present invention has been made in consideration of the above situation and has as its object to provide a metalized ceramic substrate in which no material preventing heat conduction is present between a metallic layer and a ceramic substrate so that the thermal resistance can be reduced, and a dense, high-purity metallic layer is formed so as to allow it to have a low electrical resistance.

It is another object of the present invention to provide a metalized aluminum nitride ceramic substrate and a method of manufacturing the same, in which aluminum nitride is used as a ceramic substrate to provide the above-mentioned characteristics.

According to the present invention, there is provided a method of manufacturing a metalized ceramic substrate, comprising the steps of: treating a surface of an aluminum nitride ceramic substrate using an alkali solution; and forming a metallic layer on the treated aluminum nitride ceramic substrate by electroless plating.

According to the present invention, there is provided a metalized aluminum nitride ceramic substrate comprising: an aluminum nitride ceramic substrate in the surface of which a large number of small pores are formed, and in which each pore has a structure having a larger internal size than an opening size; and a metallic layer formed on a surface of the aluminum nitride ceramic substrate including the pores.

Fig. 1 is a partially enlarged sectional view of a metalized aluminum nitride substrate according to the present invention;

Fig. 2 is a photograph of a scanning electron microscope showing the shape of pores formed in the ceramic substrate of the present invention;

Fig. 3 is a graph showing the relationship between a peel strength between the ceramic substrate and the metallic layer and the number of pores;

Fig. 4 is a graph showing the relationship between a dipped time in NaOH and the peel strength; and
Fig. 5 is a graph showing the relationship between a dipped time in a alkali solution and the peel strength.

As is well known, aluminum nitride causes hydrolysis with alkali ions. The present inventors found that when aluminum nitride ceramic is dipped in an aqueous alkali solution, small grains of the ceramic are selectively etched and, as a result, small pores are formed in the surface of the ceramic. It was also found that each pore is a jar-like column or anchor whose diameter gradually increases from the surface toward the inside thereof, resulting in that a metal can be filled in the pores in the surface of the aluminum nitride ceramic substrate by electroless plating, and a metallic layer having a superior bonding property to that of the conventional structure can be formed on the aluminum nitride ceramic substrate.

(Example 1)

An aluminum nitride substrate prepared by a normal sintering method was subjected to ultrasonic washing in ethanol for 10 minutes.
Thereafter, the substrate was dipped in an aqueous sodium hydroxide solution adjusted to a concentration of 1 mol/dm$^3$ at a room temperature for a predetermined period of time.
After dipping, the substrate was washed with water, and was dipped in a commercially available one-pack type catalyst (e.g., HS-101B available from HITACHI KASEI CO.) for four minutes.
After the substrate was washed with water, it was dipped in a promoter (e.g., ADP-101 available from HITACHI KASEI CO.) for one minute.
Subsequently, the substrate was washed with water and was dipped in a nickel electroless plating bath having the composition shown in Table 1 below, thus performing nickel electroless plating. The substrate was dipped in the plating bath for 80 minutes to have a plating thickness of about 2 μm from the surface of the substrate and to fill pores formed in the surface of the substrate, thereby allowing precipitation of nickel. The substrate was then washed with water and was dried. The nickel plating bath was kept at a temperature of 90°C, the pH was adjusted to 4.0 by means of H$_2$SO$_4$.

Table 1

| Electroless Plating Bath Composition | Concentration (mol/dm$^3$) |
|---|---|
| NiSO$_4$·7H$_2$O | 0.1 |
| C$_3$H$_4$(OH)(COONa)$_3$·2H$_2$O | 0.2 |
| NaH$_2$PO$_2$·H$_2$O | 0.15 |
| (NH$_4$)$_2$SO$_4$ | 0.50 |
| pH = 4.0 (adjusted by H$_2$SO$_4$)    Bath temperature:90°C | |

(Example 2)

An aluminum nitride substrate prepared by a normal sintering method was subjected to ultrasonic washing in ethanol for 10 minutes.
Thereafter, the substrate was dipped in an aqueous potassium hydroxide solution adjusted to a concentration of 1 mol/dm$^3$ for 60 minutes.
After dipping, the substrate was washed with water and was dipped in a commercially available one-pack type catalyst (e.g., HS-101B available from HITACHI KASEI CO.) for four minutes.
After washing with water, the substrate was dipped in a promoter (e.g., ADP-101 available from HITACHI KASEI CO.) for one minute.
Subsequently, the substrate was washed with water and was dipped in a copper electroless plating bath having the composition shown in Table 2 below, thus performing copper electroless plating. The substrate was dipped in the plating bath for 80 minutes to have a plating thickness of about 2 μm from the surface of the substrate and to fill the pores formed in the surface of the substrate. The substrate was washed with water and then dried.
The copper plating bath was kept at a temperature of 60°C, the pH was adjusted to 12.5 by means of NaOH.

## Table 2

| Electroless Plating Bath Composition | Concentration |
|---|---|
| $CuSO_4 \cdot 5H_2O$ | $0.04 \ mol/dm^3$ |
| EDTA4Na | $0.08 \ mol/dm^3$ |
| HCHO | $0.05 \ mol/dm^3$ |
| $(C_5H_4N)_2$ | $20 \ mg/dm^3$ |
| $K_4[Fe(CN)_6]$ | $50 \ mg/dm^3$ |
| pH = 12.5 (adjusted by NaOH)    Bath temperature:60°C | |

(Example 3)

An aluminum nitride ceramic substrate prepared by a hot-press method was dipped in a degreasing alkali solution of pH 12 (e.g., CERACLEAN available from K.K. KIZAI) at a temperature of 70°C for a predetermined period of time. After dipping, the substrate was sufficiently washed with water, and nickel electroless plating was performed by a normal electroless plating process. In this example, a process using a commercially available electroless plating system is exemplified. After the ceramic substrate was washed with water, it was subjected to ultrasonic washing for five minutes using ion-exchange water. Thereafter, in order to sensitize, the substrate was dipped in a sensitization solution (e.g., CERASENSI available from K.K. KIZAI) at a temperature of 18°C to 22°C for five minutes. After washing, the substrate was dipped in a catalyst additive solution (e.g., ACTICERA available from K.K. KIZAI) at a temperature of 25°C to 30°C for five minutes. After washing with water, the substrate was dipped in an activation solution (e.g., CERA-ACCE available from K.K. KIZAI) at a temperature of 25°C to 30°C for three minutes.

Further, the substrate was dipped in an electroless plating solution (e.g., a NAIKO CER available from K.K. KIZAI) at a temperature of 90°C for one minute. After washing with water, the substrate was dried at a temperature of 150°C for 30 minutes. With this process, a nickel metallic film having a thickness of about 1 μm was formed on the aluminum nitride substrate from the surface thereof.

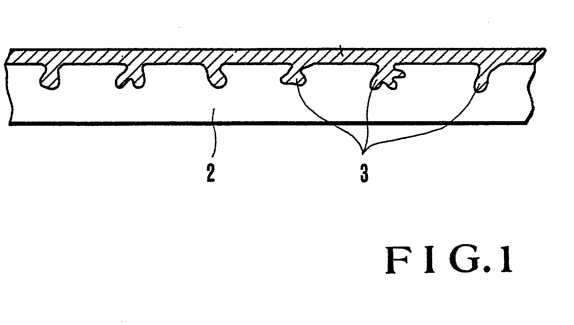

Fig. 1 is a sectional view illustrating the aluminum nitride ceramic substrate obtained by the manufacturing method of Example 3. As shown in Fig. 1, a metallic layer 1 is formed on the surface of a ceramic substrate 2, and a metal is filled in jar-like small pores, thus forming metallic columns or anchors.

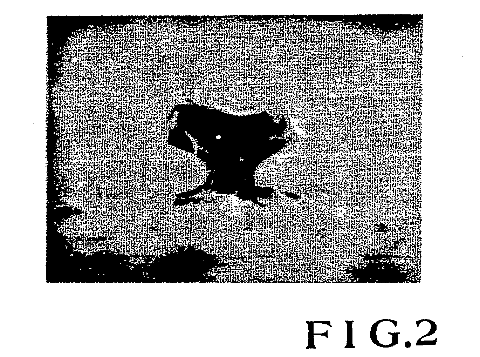

Fig. 2 is a photograph, taken by a scanning electron microscope, showing a structure obtained such that the metalized aluminum nitride ceramic substrate manufactured by the example 1 is subjected to etching to remove the ceramic portion and to leave only a metallic layer, viewed from the side of a ceramic interface. As can be seen from Fig. 2, jar-like metallic columns filled in the pores formed in the surface of the ceramic substrate can be observed.

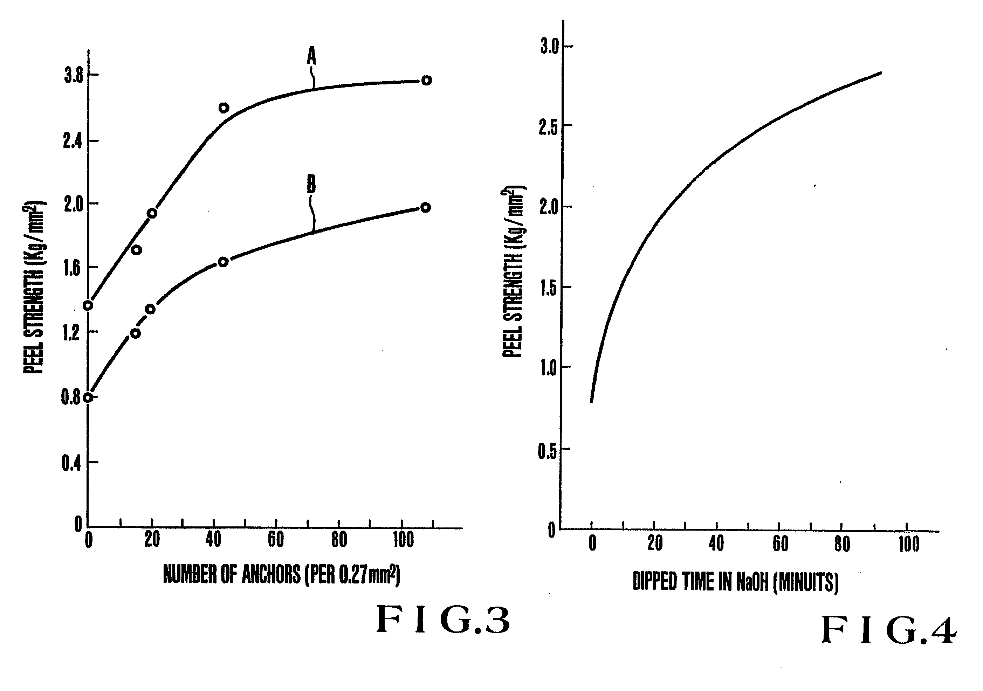

Fig. 3 shows the relationship between the number of anchors 3 and the peel strength between the metallic layer and ceramic substrate, in example 1. As the number of anchors 3 increases, the peel strength is greatly improved. Referring to Fig. 3, curves A and B respectively represent changes in average value and in maximum value of the measured values.

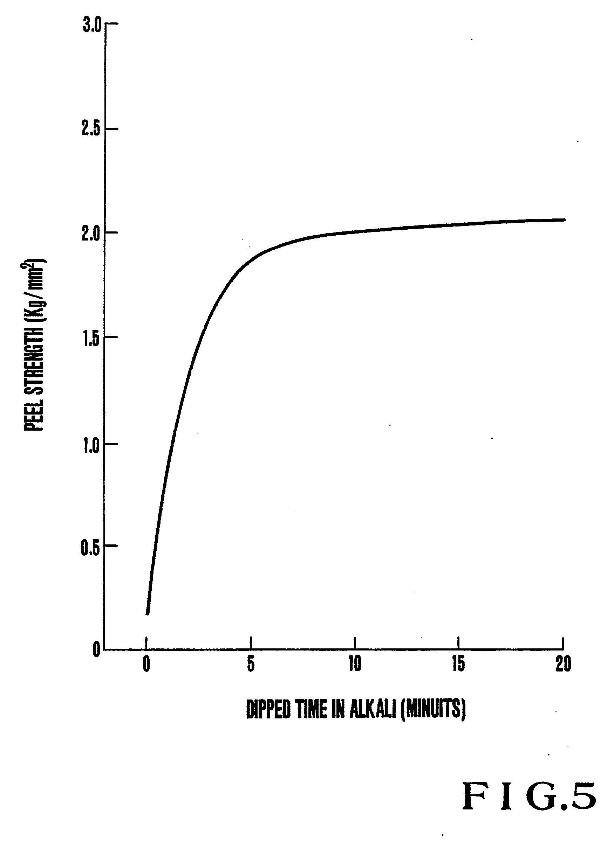

Fig. 4 shows the relationship between a dipped time in an aqueous sodium hydroxide solution and the peel strength in the example 1. Fig. 5 shows the relationship between the dipped time in an alkali solution (CERACLEAN) and the peel strength in the example 3. When the ceramic substrate is dipped in the aqueous sodium hydroxide solution, the peel strength can be noticeably improved, thus allowing practical application.

The peel strength between the metal and ceramic was measured as follows.

A resist was coated on the nickel or copper layer formed on the metalized aluminum nitride substrate in the above examples, and a predetermined area thereof was exposed and developed using a photomask. The developed substrate was dipped in a nickel or copper etching solution to form a 2 mm x 2 mm nickel or copper pad.

A lead wire was soldered to the thus formed pad, and the peel strength was measured using a tensile machine.

4

Alkalis for surface treating the aluminum nitride ceramic substrate include aqueous solutions of hydroxides, carbonates or sodium bicarbonates of alkali metals, (e.g., sodium hydroxide, potassium hydroxide, lithium hydroxide, and the like) or of alkali earth metals, and alkali aqueous solutions having an alkaline property, e.g., ammonia, amine, and the like. In a method for forming a metallic layer by electroless plating, any one of acidic, alkaline, and neutral baths can be used. Metals include all the metals which are capable of electroless plating, e.g., silver, gold, chromium, iron and the like, in addition to nickel and copper.

In the above examples, electroless plating is performed using catalyst processes, e.g., a sensitization process, an activation process, an activator-accelerator method, and the like generally used in electroless plating. However, without using these catalyst processes, when the ceramic substrate after washing was simply dipped in an electroless plating bath to allow metal precipitation, a peel strength of 2 kg/mm² or higher could be realized.

As described above, the metalized aluminum nitride ceramic substrate has very high peel strength between metal and ceramic due to an anchor effect.

Since no intermediate layer is present between the metallic layer and ceramic substrate and a bonding area between metal and ceramic can be effectively widened, a thermal resistance between the metallic layer and ceramic substrate can be greatly reduced.

As for the wiring pattern precision for an electronic circuit board, since the metallic layer is strongly bonded to the ceramic substrate, a micro circuit pattern can be formed as in a thin film method by an etching method using a photosensitive resin. Since no intermediate layer is present, a decrease in peel strength due to etching will not occur.

With the above structure, since the reliability of the metallic layer can be improved, variations caused in the manufacture of substrates can be reduced, thus greatly reducing cost by mass-production.

Note than in the above examples, the metallic layer consists of an identical metal. However, anchors and a surface layer can consist of different metals.

**Claims**

1. A method of manufacturing a metalized aluminum nitride ceramic substrate comprising the steps of: treating a surface of an aluminum nitride ceramic substrate (2) using an alkali solution; and forming a metallic layer (1) on the treated aluminum nitride ceramic substrate (2) by electroless plating.

2. A metalized aluminum nitride ceramic substrate comprising: an aluminum nitride ceramic substrate (2) in the surface of which a large number of small pores (3) are formed, and in which each pore has a structure having a larger internal size than an opening size; and a metallic layer (1) formed on a surface of said aluminum nitride ceramic substrate (2) including the pores (3).

3. A metalized aluminum nitride ceramic substrate according to claim 2, wherein a peel strength between said aluminum nitride ceramic substrate (2) and said metallic layer (3) is at least 2 kg/mm².

**Patentansprüche**

1. Herstellungsverfahren für einen metallisierten Aluminiumnitrid-Keramikträger mit den Schritten: Behandeln einer Oberfläche eines Aluminiumnitrid-Keramikträgers (2) unter Verwendung einer alkalischen Lösung; und Ausbilden einer Metallschicht (1) auf dem behandelten Aluminiumnitrid-Keramikträger (2) durch elektrofreies Plattieren.

3. Metallisierter Aluminiumnitrid-Keramikträger mit: einem Aluminiumnitrid-Keramikträger (2), in dessen Oberfläche eine große Anzahl von kleinen Poren (3) ausgebildet ist und in dem jede Pore eine Struktur hat, die ein größeres Innenausmaß als eine Öffnungsweite aufweist; und einer Metallschicht (1), die auf einer Oberfläche des Aluminiumnitrid-Keramikträgers (2), die die Poren (3) aufweist, ausgebildet ist.

3. Metallisierter Aluminiumnitrid-Keramikträger nach Anspruch 2, bei dem eine Haftstärke zwischen dem Aluminiumnitrid-Keramikträger (2) und der Metallschicht (3) zumindest 2 kg/mm² beträgt.

**Revendications**

1. Procédé de fabrication d'un substrat en céramique de nitrure d'aluminium métallisé, comprenant les étapes consistant à: traiter une surface du substrat (2) en céramique de nitrure d'aluminium en utilisant une solution d'alcali; et former par revêtement autocatalytique une couche métallique (1) sur le substrat (2) en céramique de nitrure d'aluminium traité.

2. Substrat en céramique de nitrure d'aluminium métallisé comprenant: un substrat (2) en céramique de nitrure d'aluminium dans la surface duquel un grand nombre de petits pores (3) sont formés, et dans lequel chaque pore présente une structure ayant un diamètre interne plus grand qu'un diamètre d'ouverture; et une couche métallique (1) formée sur la surface du substrat (2) en céramique de nitrure d'aluminium comprenant les pores (3).

3. Substrat en céramique de nitrure d'aluminium métallisé selon la revendication 2, dans lequel la résistance au détachement entre le substrat (2) en céramique de nitrure d'aluminium et la couche métallique (3) est au moins 2 kg/mm².

5

F I G.1

FIG.2

FIG.3

FIG.4

EP 0 219 122 B1

FIG.5